# EUROPEAN PATENT APPLICATION

(11) **EP 4 741 921 A1**
(43) Date of publication of application: **13.05.2026**
(21) Application number: 24211154.0
(22) Date of filing: 06.11.2024
(51) Int. Cl.: G03F 7/00, H01L 21/683

(54) **ELECTROSTATIC OBJECT SUPPORT AND METHODS OF MANUFACTURE THEREOF**

(71) Applicant: ASML Netherlands B.V., 5500 AH Veldhoven (NL)
(72) Inventor: SCHMIDT, Volker, 5500 AH Veldhoven (NL)
(74) Representative: ASML Netherlands B.V.

(57) **Abstract**

Disclosed is an electrostatic object support for supporting an object. The electrostatic object support comprises a base layer; an electrode on said base layer and at least one dielectric layer extending fully over the electrode, wherein the at least one dielectric layer comprises a first coated dielectric sub-layer being comprised of a first dielectric material and a second coated dielectric sub-layer being comprised of a second dielectric material.

## Description

### FIELD

The present invention relates to exposure apparatuses or lithographic apparatuses used in the manufacture of integrated circuits. In particular, the present invention relates to an electrostatic object support, such as an electrostatic reticle support or electrostatic substrate support for such apparatuses. More generally, the present invention relates to electrostatic object supports for supporting any object.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

EUV lithographic devices use reflective optics to prevent the absorption of the EUV radiation by transmissive elements. These reflective optics include the patterning device, typically referred to as the "mask" or "reticle" (all three terms are synonymous), to pattern a radiation beam. The patterned radiation beam is then used to expose a portion of a substrate. Each of the patterning device and substrate is supported by a respective object support, i.e., a patterning device support and a substrate support.

To prevent absorption of the EUV radiation used in an EUV lithographic device, the patterning device and substrate may be operated within a vacuum environment, making it impossible to use vacuum clamps for the object supports. As such, the clamping of each object to its respective support may be performed using an electrostatic object support, e.g., an electrostatic clamp.

It would be desirable to improve on present electrostatic object supports.

### SUMMARY

In a first aspect of the invention, there is provided an electrostatic object support for supporting an object, the electrostatic object support comprising: a base layer; an electrode on said base layer and at least one dielectric layer extending fully over the electrode, wherein the at least one dielectric layer comprises at least a first coated dielectric sub-layer being comprised of a first dielectric material and a second coated dielectric sub-layer being comprised of a second dielectric material, the second dielectric material being different from said first dielectric material.

In a second aspect of the invention, there is provided a method of manufacturing an electrostatic object support, comprising: obtaining a base layer comprising an electrode; coating said electrode with a first dielectric material using a first coating process to obtain a first coated dielectric sub-layer; and coating said first coated dielectric sub-layer with a second dielectric material using a second coating process to obtain a second coated dielectric sub-layer; wherein said first dielectric material is different from said second dielectric material; and wherein said first coating process is different from said second coating process.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2(a) is a top view and Figure 2(b) is a side view schematic illustration of an electrostatic clamp;
- Figure 3 is a schematic illustration of a first electrostatic clamp according to concepts disclosed herein; and
- Figure 4 is a schematic illustration of a second electrostatic clamp according to concepts disclosed herein.

### DETAILED DESCRIPTION

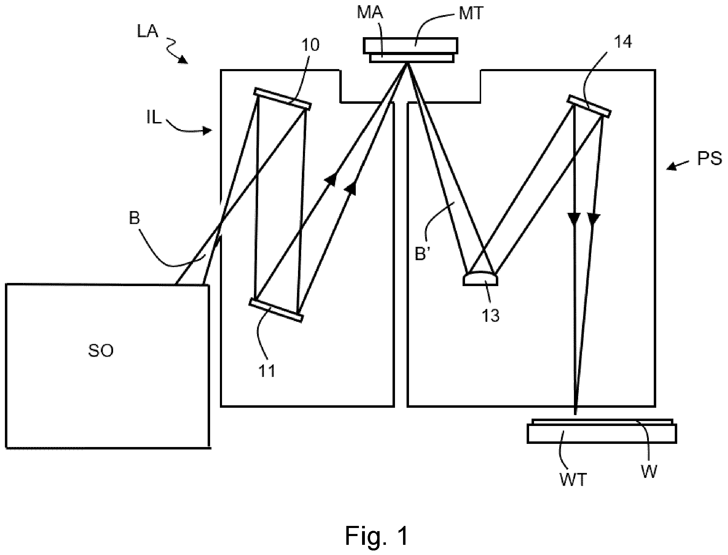

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT (or reticle stage) configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device (or reticle) MA. The support structure MT, hereafter a reticle stage, may support the patterning device MA by clamping it electrostatically, and may be configured to scan the patterning device MA during exposures. As a result of the interaction of EUV radiation beam B and patterning device MA, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

The substrate to be exposed may be supported by a substrate holder (i.e. the object that directly supports a substrate), which in turn is supported by a position module for moving the substrate holder relative to the patterned radiation beam, for example. The substrate holder may have an array of projections, referred to as burls, projecting from at least one side. When the substrate rests on the top of the burls on the at least one side of the substrate holder, the substrate may be spaced apart from a main body of the substrate holder. This may aid in the prevention of a particle (i.e. a contaminating particle such as a dust particle), which may be present on the substrate holder, from distorting the substrate holder or substrate. The total surface area of the burls may only be a small fraction of the total area of the substrate or substrate holder. As such, it is more probable that any particle will lie between burls and its presence will have no effect.

Due to the high accelerations that may be experienced by the substrate in use of a high-throughput lithographic apparatus, it may be insufficient to allow the substrate simply to rest on the burls of the substrate holder. Instead, the substrate is clamped in place. Two methods of clamping the substrate in place may be used: vacuum clamping and electrostatic clamping. In vacuum clamping, the space between the substrate holder and substrate and optionally between the substrate table and substrate holder are partially evacuated so that the substrate is held in place by the higher pressure of gas or liquid above it. Vacuum clamping, however, may not be used where the beam path and/or the environment near the substrate or substrate holder is kept at a low or very low pressure, e.g. for extreme ultraviolet (EUV) radiation lithography. In this case, it may not be possible to develop a sufficiently large pressure difference across the substrate (or substrate holder) to clamp it. Electrostatic clamping may, therefore, be used. In electrostatic clamping, a potential difference is established between the substrate and the substrate holder. The potential difference may generate a clamping force.

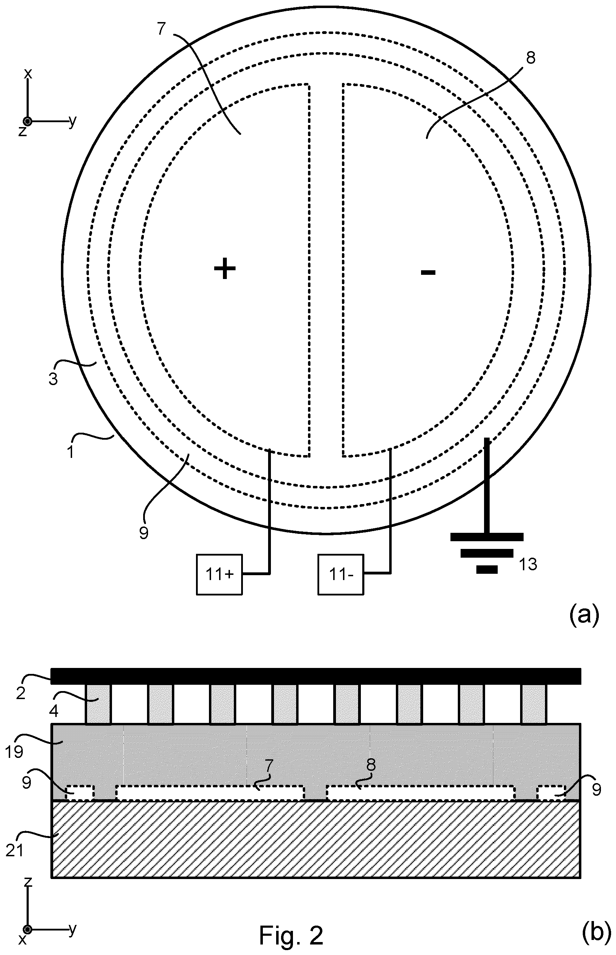

Figure 2 depicts (a) a plan view and (b) a side view of an electrostatic object support 1, hereafter an electrostatic clamp, which may form part of an object support 3 for supporting an object 2 (such as a substrate W or reticle MA). The object 2 is disposed on the object support 3. To maintain the object 2 supported in a stable manner on the support, the clamp 1 provides a clamping force, i.e., the object 2 is attracted onto the object support 3, for instance, by electrostatic clamping. More specifically, the object 2 may be supported on top of the protrusions or burls 4 (not shown on Figure 2(a)) protruding from the object support, such as described with reference to EP0947884 which is incorporated herein by reference.

The electrostatic clamp comprises an electrode 7, 8, 9. The electrode 7, 8, 9 may comprise a single electrode portion or two or more electrode portions which are insulated (or isolated) from each other. In the example shown, the electrode comprises a first electrode portion 7, a second electrode portion 8 and a third electrode portion (e.g. a shielding electrode portion) 9. At least one voltage supply may be provided which is configured to supply a voltage to the first electrode portion 7 and/or second electrode portion 8. In the specific example shown, opposite polarity voltages may respectively be applied to the first electrode portion 7 and second electrode portion 8: e.g., a positive supply 11+ is provided to the first electrode portion 7 and a negative supply 11- provided to the second electrode portion 8. In this way, the object 2 remains neutrally charged. The third electrode portion 9 may be grounded by the provision of an earth connection 13. The actual sizes and locations of these electrode portions may vary from that shown, e.g., the first electrode portion 7 and second electrode portion 8 may extend over more of the clamp (i.e., in x and/or y), with the third electrode portion 9 being closer to the perimeter.

The electrostatic clamp 1 comprises a stack arranged such that a first or upper surface of the electrode 7, 8, 9 is in contact with a first dielectric (or semi-dielectric) layer 19 and a second surface or lower surface of the electrode is in contact with a second dielectric (or semi-dielectric) layer 21. The dielectric layers 19, 21 are provided in order to maintain a charge provided on at least the first electrode portion 7. In Figure 2, the electrode 7, 8, 9 is depicted in dotted lines in order to indicate that the electrode is disposed within the stack structure of the electrostatic clamp 1. In other words, the electrode is not disposed on an outer surface of the clamp 1. Further, the electrical connections to the voltage supply 11 and earth 13 may also be provided within the stack structure of the electrostatic clamp 1. The burls 4 may be integral with the dielectric layer 19. Burls 4 may in that case have a conductive top coating. Alternatively, burls 4 of a conductive material may be provided on the dielectric layer 19. Apart from electrical conductivity, such top coating or burl material provides a relatively hard substrate support surface layer. Although not shown, the electrostatic clamp may additionally have burls on the bottom side so as to support and clamp the electrostatic clamp on a support structure such as a position module to move the electrostatic clamp, for example relative to a patterned EUV radiation beam, during use.

Typically, the dielectric layers 19, 21 are comprised of a glass material, such as a form of quartz glass. Such a dielectric material may have a very high volume resistance (e.g., 10²⁰ Q/cm) and a breakthrough voltage of e.g., 20 to 40 V/µm.

A disadvantage of the use of glass is the relatively low fracture toughness of glass. It is desirable to improve the wear resistance of the clamp, but there seems to be a limit to the wear resistance of such combination of hard conductive coatings or burl materials and relatively soft underlying dielectrics.

To improve this situation other dielectric materials with better fracture toughness can be chosen. This could be e.g. silicon nitride. Silicon nitride has a very good fracture toughness, but may not be sufficiently hard in itself for such high-load applications. This is because many wafer backsides are coated with silicon nitride, and therefore the wafer backside and clamping surface have equal hardness.

An electrostatic object support (electrostatic clamp) is proposed which comprises at least a base layer, an electrode and at least one dielectric layer extending fully over the electrode and which comprises a first coated dielectric sub-layer being comprised of a first dielectric material and a second coated dielectric sub-layer being comprised of a second dielectric material.

The first coated dielectric sub-layer and a second coated dielectric sub-layer may each be coated onto the electrode, e.g., by applying a first coating onto the electrode (e.g., onto the electrode upper surface such that it is between the electrode and object to be clamped) to form said first coated dielectric sub-layer, and applying a second coating onto the first coated dielectric sub-layer to form said second coated dielectric sub-layer.

The dielectric strength of each of the sub-layers may be greater than 1 MV/cm, greater than 2 MV/cm greater than 3 MV/cm greater than 4 MV/cm or greater than 4.5 MV/cm for example.

For example, the first dielectric material may comprise and/or consist of silicon nitride and the second dielectric material may comprise and/or consist of diamond, e.g., microcrystalline diamond.

In view of the interest in reducing the distance between clamp electrodes and object, it is preferred that only a thin dielectric layer is provided on the electrode. In an embodiment, each of the first sub-layer and second sub-layer may comprise a thickness less than 4µm, less than 3µm or less than 2.5µm. In an embodiment, each of the first sub-layer and second sub-layer may comprise a thickness greater than 0.5µm. As such, the first sub-layer and/or the second sub-layer may each comprise a film layer. In an example, wherein the first dielectric material comprises silicon nitride and the second dielectric material comprises microcrystalline diamond, the first sub-layer may comprise a thickness of between 1.5µm and 2.5 µm and second sub-layer may comprise a thickness of between 0.75µm and 1.5 µm.

In general, such thin layers of coated dielectrics have the general disadvantage that they are sensitive to voltage breakthroughs such as because of defects like pinholes. Therefore, a single, thin layer of microcrystalline diamond or of silicon nitride may be ineffective as dielectric. The inventor has determined that a dual layer coating of two different dielectric materials, preferably silicon nitride and microcrystalline diamond, addresses this issue. Each of these coatings may be chosen, in dependence on the electrode voltage or voltages used during use, to be sufficiently thick to withstand the voltage of the clamp alone, such that there is no or at least a significantly reduced chance of a breakthrough in case of a defect in one sub-layer.

It is further proposed that the two sub-layers may be formed by different coating processes. For example, the silicon nitride sub-layer may be applied by a first coating process such as a sputtering process and the diamond layer applied by a second coating process such as a chemical vapor deposition (CVD) process. By doing this, it can be assumed that pinholes will, at least to a larger extent, be at different locations which further reduces the risk of voltage breakthroughs.

The base layer may be glass or ceramic (e.g. ceramic silicon nitride), for example. The burls may be integral with (e.g., formed from/within) the base layer.

The electrode and the at least one dielectric layer may be formed (e.g., coated) to extend over at least a portion of the clamp surface between burls. The electrode and the at least one dielectric layer may be formed to extend over at least a portion of a respective top surface of at least some of the burls (e.g., all of the burls) in addition to locations between the burls. In such an example, the electrode and the at least one dielectric layer may be formed from conformal coatings over the clamp surface including the burls. Clamping only on the burl surfaces may be relatively sensitive to particles between burl and object, resulting in regions of insufficient clamping force.

By providing an electrode on the burls (in addition to between burls), distortion of the held object in regions between burls and/or the clamping voltage may however be reduced. Such an arrangement also provides the opportunity for much greater clamping forces then presently possible (e.g., up to 1000 bar). This contributes to preventing local slipping of the object (distortion) which might occur due to thermal load effects.

Both microcrystalline diamond and silicon nitride have very high dielectric strength (i.e., 10 MV/cm for microcrystalline diamond and 5 MV/cm for silicon nitride). This makes it possible to use a combination of 1µm microcrystalline diamond on 2µm silicon nitride, for example. A clamp voltage of around 1000 V may be sufficient, in that case.

The volume resistance of both microcrystalline diamond and coated silicon nitride may not be as high as would ideally be desirable (e.g., some orders of magnitude lower than the glass materials presently used), which can lead to an additional polarization current in the dielectric. However, due to the small thickness of the layer in many of the proposed examples, the time constant of this effect is low. Therefore this lower volume resistance does not present a problem. Thus, by providing an electrostatic object support in accordance with the concepts disclosed herein, a highly wear resistant clamp may be provided having a very small dielectric layer thickness while still having a very high breakthrough strength at an acceptable volume resistance.

In a simplest example, there may be a single, one-piece electrode. In other examples, as with the example of Figure 2, the electrode may comprise two electrode portions electrically insulated from each other to allow for voltages applied to the two electrodes to be independently and/or separately controlled. For example, voltages of opposite polarities may be applied to the two electrodes, such that the electrostatic clamp is implemented as a bipolar electrostatic clamp. It will be appreciated that in other examples, the electrode may be configured as more than two electrode portions, e.g. to form a multipolar electrostatic clamp. In any of the arrangements described, the electrode may comprise a (e.g., grounded) shielding electrode portion (e.g., around the periphery of the clamp and/or surrounding the main electrode portion(s) such as illustrated in Figure 2).

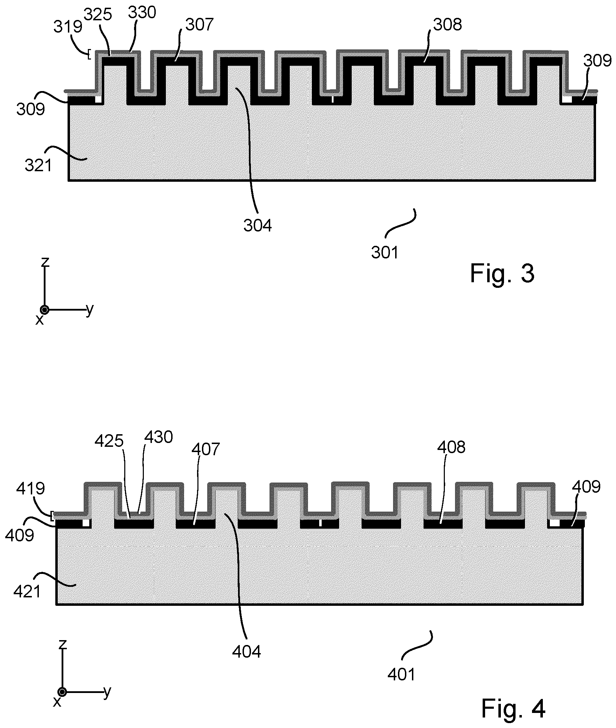

Figure 3 is a schematic illustration of an electrostatic clamp 301 according to a first example. Electrostatic clamp 301 comprises a base layer 321, for example of silicon nitride, having integral burls 304; e.g., the burls 304 are formed within the base layer 321 material. This is optional, the burls 304 may alternatively be attached to a base layer 321. An electrode 307, 308, 309 may be formed in three electrode portions: a first electrode portion 307 (e.g., to be attached to a first voltage supply), a second electrode portion 308 (e.g., to be attached to a second voltage supply) and, optionally, a third or shielding electrode portion 309. The electrode 307, 308, 309 may be formed as a coating layer, coated onto the base layer 321, so as to be conformal with the burls and with each electrode portion electrically insulated from each other. The electrode 307, 308, 309 may comprise an electrode material such as a high temperature resistant metal; e.g., Titanium or Molybdenum.

A dielectric layer 319 is applied onto the electrode 307. The dielectric layer 319 comprises a first coated dielectric sub-layer 325 and second coated dielectric sub-layer 330. The first coated dielectric sub-layer 325 may comprise silicon nitride. For example, the first coated dielectric sub-layer 325 may comprise a silicon nitride film, e.g., of an above-mentioned thickness, formed by a sputtering process on the electrode layer. The second coated dielectric sub-layer 330 may comprise a diamond layer, e.g., a microcrystalline diamond layer, e.g., of an above-mentioned thickness. For example, the second coated dielectric sub-layer 330 may be formed via a CVD process on the first coated dielectric sub-layer 325. The dielectric layer 319 should extend over the full electrode area.

This example increases the maximum clamp force generated, as the burls themselves generate a clamp force in addition to the space between the burls. The local clamp force on the burls will be much higher than the clamp force between the burls, which could be an advantage in preventing or reducing thermal load drift.

Figure 4 is a schematic illustration of an electrostatic clamp 401 according to a second example. As before, electrostatic clamp 401 again comprises a base layer 421 comprising burls 404 (e.g., integral with the base layer 421). Again, as before, electrode 407, 408, 409 may be formed in three electrode portions: a first electrode portion 407, a second electrode portion 408 and a third or shielding electrode portion 409. However in this example, the burls comprise no electrode 407, 408, 409. As such, the electrode 407, 408, 409 only extends over one or more areas between the burls 404, for example by first coating the entire base layer and then removing the electrode coating from the burl tops. As with the previous example, the dielectric layer 419, comprising the first coated dielectric sub-layer 425 and second coated dielectric sub-layer 430, extends over one or more areas between the burls 404 as well as over the burls.

The electrode and sub-layers may be formed of the same materials and using the same methods as has been already described in relation to Figure 3. As such, the layers may be applied over the surfaces including burls as before, with an additional step of removing the electrode layer from the burl surfaces. Of course, other methods (e.g., coating only the areas between the burls) are possible. In an embodiment, only the second coated dielectric sub-layer 430 extends over the burls while the electrode and first coated dielectric sub-layer 425 only extend between the burls, for example by removing the electrode and first coated dielectric sub-layer from the (e.g., top) burl surfaces after coating.

In all examples and embodiments, the actual arrangement of electrode 307, 308, 309, 407, 408, 409, the area(s) of burl 304 and/or base layer 321, 421 covered by the electrode 307, 308, 309, 407, 408, 409, (and therefore dielectric layer 319, 419), the burl 304, 404 arrangement and the number of electrode portions may differ from the arrangements shown. For example, in the Figure 3 arrangement, the electrode and/or dielectric layer may be removed from the side of the burls (shown as vertical surfaces in Figure 3).

Advantages of the concepts disclosed herein include providing a very robust contact area (burl area) with the object, enabling several million object passes, e.g., particularly using silicon nitride with a CVD-Diamond overcoating on the burls. In addition, the heat conductivity between the object (e.g., wafer) and the water-cooled baseplate of the chuck is significantly better than, e.g., with a dielectric glass. A CVD-Diamond coating has an extremely high heat conductivity of 2000 W/m*K and supports the heat conduction as a heat spreader. Additionally, providing a clamp force on top of the burls could significantly reduce possible local sliding of a wafer over burls due to thermal effects. Depending on the roughness on top of the burls, it may be possible to generate a local clamp pressure which exceeds 1000 bar. Finally, the manufacturing process of such a clamp is less complex than for a glass dielectric. For example, no bonding process is needed between the dielectric and the base plate.

Although the object support disclosed herein is described for use within an EUV lithographic apparatus, its utility is not so limited. Such an object support may be used as a patterning device support and/or a substrate support in any lithographic apparatus which uses radiation of any wavelength(s) to pattern a substrate. More generally, such an object support may be used as a substrate support in any other device for which it is required to support and move a substrate, such as a metrology device (e.g., a scatterometer, e-beam apparatus/electron microscope apparatus, and/or any other microscope apparatus (e.g., a holographic microscope apparatus)). More generally still, such an object support may be used in any context for electrostatically supporting any object in any context, whether in a lithography context or otherwise.

It will be understood that embodiments of the present invention may be applied to any object, in particular, a flat object. In particular, the object may be any object to be placed in a projection beam, such as an optical element e.g., a reflective or transmissive mask, or a substrate to be irradiated, such as a wafer.

Further embodiments are described in the following numbered clauses:
1. An electrostatic object support for supporting an object, the electrostatic object support comprising: a base layer; an electrode on said base layer; and at least one dielectric layer extending fully over the electrode, wherein the at least one dielectric layer comprises at least a first coated dielectric sub-layer being comprised of a first dielectric material and a second coated dielectric sub-layer being comprised of a second dielectric material, the second dielectric material being different from said first dielectric material.
2. An electrostatic object support according to clause 1, wherein the first coated dielectric sub-layer has been coated on the electrode and the second coated dielectric sub-layer has been coated on the first coated dielectric sub-layer.
3. An electrostatic object support according to clause 1 or 2, wherein the dielectric strength of each of the sub-layers is greater than 1 MV/cm.
4. An electrostatic object support according to clause 1 or 2, wherein the dielectric strength of each of the sub-layers is greater than 4 MV/cm.
5. An electrostatic object support according to any preceding clause, wherein the first coated dielectric sub-layer has been formed by a first coating process and the second coated dielectric sub-layer has been formed by a second coating process, being different to said first coating process.
6. An electrostatic object support according to clause 5, wherein the first coating process comprises a sputtering process.
7. An electrostatic object support according to clause 5 or 6, wherein the second coating process comprises a chemical vapor deposition process.
8. An electrostatic object support according to any preceding clause, wherein the first dielectric material comprises silicon nitride.
9. An electrostatic object support according to any preceding clause, wherein the second dielectric material comprises diamond.
10. An electrostatic object support according to any preceding clause, wherein the second dielectric material comprises microcrystalline diamond.
11. An electrostatic object support according to any preceding clause, wherein each of the first coated dielectric sub-layer and second coated dielectric sub-layer comprises a thickness less than 4µm.
12. An electrostatic object support according to any preceding clause, wherein each of the first coated dielectric sub-layer and second coated dielectric sub-layer comprises a thickness less than 3µm.
13. An electrostatic object support according to any preceding clause, wherein each of the first coated dielectric sub-layer and second coated dielectric sub-layer comprises a film layer.
14. An electrostatic object support according to any preceding clause, wherein said base layer comprises a glass or ceramic material.
15. An electrostatic object support according to any preceding clause, further comprising a plurality of burls for supporting the object thereon.
16. An electrostatic object support according to clause 15, wherein said burls are integral with the base layer.
17. An electrostatic object support according to clause 15 or 16, wherein said electrode and the at least one dielectric layer extends over at least a portion of the clamp surface between said burls.
18. An electrostatic object support according to clause 15, 16 or 17, wherein said electrode and the at least one dielectric layer extends over at least a portion of a respective top surface of at least some of said plurality of burls.
19. An electrostatic object support according to clause 15, 16 or 17, wherein said electrode and the at least one dielectric layer extends over at least a portion of a respective top surface of all of said plurality of burls.
20. An electrostatic object support according to any preceding clause, wherein said electrode comprises at least a first electrode portion and a second electrode portion, each electrically insulated from the other.
21. An electrostatic object support according to clause 20, further comprising a first voltage supply for supplying a first voltage to the first electrode portion and a second voltage supply for supplying a second voltage to the second electrode portion.
22. An electrostatic object support according to any preceding clause, wherein said electrode comprises a grounded shielding electrode portion.
23. An electrostatic object support according to any preceding clause, being configured for clamping a substrate thereto.
24. An electrostatic object support according to any of clauses 1 to 22, being configured for clamping a patterning device thereto.
25. A lithographic apparatus comprising:
   at least one of:
   an electrostatic object support according to clause 23 being configured to retain a substrate to be patterned; and/or
   an electrostatic object support according to clause 24 being configured to retain a patterning device for patterning a beam of radiation.
26. A metrology and/or inspection apparatus, comprising:
   an electrostatic object support according to clause 23 being configured to retain a substrate to be measured and/or inspected.
27. A method of manufacturing an electrostatic object support, comprising:
   obtaining a base layer comprising an electrode;
   coating said electrode with a first dielectric material using a first coating process to obtain a first coated dielectric sub-layer; and
   coating said first coated dielectric sub-layer with a second dielectric material using a second coating process to obtain a second coated dielectric sub-layer;
   wherein said first dielectric material is different from said second dielectric material; and
   wherein said first coating process is different from said second coating process.
28. A method according to clause 27, wherein the dielectric strength of each of the sub-layers is greater than 1 MV/cm.
29. A method according to clause 27, wherein the dielectric strength of each of the sub-layers is greater than 4 MV/cm.
30. A method according to any of clauses 27 to 29, wherein the first dielectric material comprises silicon nitride.
31. A method according to any of clauses 27 to 30, wherein the second dielectric material comprises diamond.
32. A method according to any of clauses 27 to 31, wherein the second dielectric material comprises microcrystalline diamond.
33. A method according to any of clauses 27 to 32, wherein each of the first coated dielectric sub-layer and second coated dielectric sub-layer are coated to a thickness of less than 4µm.
34. A method according to any of clauses 27 to 33, wherein each of the first coated dielectric sub-layer and second coated dielectric sub-layer layer are coated to a thickness of less than 3µm.
35. A method according to any of clauses 27 to 34, wherein the first coating process comprises a sputtering process.
36. A method according to any of clauses 27 to 35, wherein the second coating process comprises a chemical vapor deposition process.
37. A method according to any of clauses 27 to 36, comprising coating at least one or more portions of said base layer with electrode material to form said electrode.
38. A method according to clause 37, comprising coating said electrode, said first coated dielectric sub-layer and said second coated dielectric sub-layer on at least a portion of the clamp surface between said burls.
39. A method according to clause 38, further comprising coating said electrode, said first coated dielectric sub-layer and said second coated dielectric sub-layer on at least a portion of a respective top surface of at least some of said plurality of burls.
40. A method according to clause 38, further comprising coating said electrode, said first coated dielectric sub-layer and said second coated dielectric sub-layer on at least a portion of a respective top surface of all of said plurality of burls.
41. A method according to any of clauses 37 to 40, comprising forming said electrode to include at least a first electrode portion and a second electrode portion, each electrically insulated from the other.
42. A method according to clause 41, further comprising attaching a first voltage supply to the first electrode portion and a second voltage supply to the second electrode portion.
43. A method according to clause 41 or 42, comprising forming said electrode to include at least a grounded shielding electrode portion.
44. A method according to any of clauses 27 to 43, wherein said electrostatic object support comprises the electrostatic object support of any of clauses 1 to 24.
45. A method of clamping an object to an electrostatic object support, the method comprising:
   activating an electrode to clamp said object to the electrostatic object support; and
   insulating said object from said electrode using at least one dielectric layer extending fully over the electrode, wherein the at least one dielectric layer comprises at least a first coated dielectric sub-layer being comprised of a first dielectric material and a second coated dielectric sub-layer being comprised of a second dielectric material, the second dielectric material being different from said first dielectric material.
46. A method as claimed in clause 45, wherein the electrostatic object support comprises the electrostatic object support of any of clauses 1 to 24.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An electrostatic object support for supporting an object, the electrostatic object support comprising:
a base layer;
an electrode on said base layer; and
at least one dielectric layer extending fully over the electrode,
wherein the at least one dielectric layer comprises at least a first coated dielectric sub-layer being comprised of a first dielectric material and a second coated dielectric sub-layer being comprised of a second dielectric material, the second dielectric material being different from said first dielectric material.

2. An electrostatic object support as claimed in claim 1, wherein the first coated dielectric sub-layer has been coated on the electrode and the second coated dielectric sub-layer has been coated on the first coated dielectric sub-layer.

3. An electrostatic object support as claimed in claim 1 or 2, wherein the first coated dielectric sub-layer has been formed by a first coating process and the second coated dielectric sub-layer has been formed by a second coating process, being different to said first coating process.

4. An electrostatic object support as claimed in claim 3, wherein the first coating process comprises a sputtering process and/or the second coating process comprises a chemical vapor deposition process.

5. An electrostatic object support as claimed in any preceding claim, wherein the first dielectric material comprises silicon nitride; and/or wherein the second dielectric material comprises diamond.

6. An electrostatic object support as claimed in any preceding claim, wherein the second dielectric material comprises microcrystalline diamond.

7. An electrostatic object support as claimed in any preceding claim, wherein each of the first coated dielectric sub-layer and second coated dielectric sub-layer comprises a film layer.

8. An electrostatic object support as claimed in any preceding claim, further comprising a plurality of burls for supporting the object thereon.

9. An electrostatic object support as claimed in claim 8, wherein said electrode and the at least one dielectric layer extends over at least a portion of a respective top surface of at least some of said plurality of burls.

10. An electrostatic object support as claimed in any preceding claim, wherein said electrode comprises at least a first electrode portion and a second electrode portion, each electrically insulated from the other.

11. An electrostatic object support as claimed in any preceding claim, being configured for clamping a substrate thereto.

12. A lithographic apparatus comprising:
at least one of:
an electrostatic object support as claimed in claim 11, being configured to retain a substrate to be patterned; and/or
an electrostatic object support as claimed in any of claims 1 to 10, being configured to retain a patterning device for patterning a beam of radiation.

13. A metrology and/or inspection apparatus, comprising:
an electrostatic object support as claimed in claim 11, being configured to retain a substrate to be measured and/or inspected.

14. A method of manufacturing an electrostatic object support, comprising:
obtaining a base layer comprising an electrode;
coating said electrode with a first dielectric material using a first coating process to obtain a first coated dielectric sub-layer; and
coating said first coated dielectric sub-layer with a second dielectric material using a second coating process to obtain a second coated dielectric sub-layer;
wherein said first dielectric material is different from said second dielectric material; and
wherein said first coating process is different from said second coating process.

15. A method as claimed in claim 14, wherein said electrostatic object support comprises the electrostatic object support of any of claims 1 to 11.
